(19) Europäisches Patentamt
European Patent Office
Office européen des brevets

(11) **EP 4 333 052 A1**

(12) # EUROPEAN PATENT APPLICATION

(43) Date of publication:
**06.03.2024 Bulletin 2024/10**

(21) Application number: **23193937.2**

(22) Date of filing: **29.08.2023**

(51) International Patent Classification (IPC):
**H01L 23/495** (2006.01)     C25D 5/12 (2006.01)
C25D 5/14 (2006.01)     C23C 18/16 (2006.01)

(52) Cooperative Patent Classification (CPC):
**H01L 23/49582;** C23C 18/165; C25D 5/12;
C25D 5/14

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.09.2022 JP 2022139760**

(71) Applicant: **Mitsui High-Tec, Inc.**
**Kitakyushu-shi, Fukuoka 807-8588 (JP)**

(72) Inventors:
• **KOGA, Kento**
  **Kitakyushu-shi, Fukuoka, 807-8588 (JP)**
• **SUGYO, Shintaro**
  **Kitakyushu-shi, Fukuoka, 807-8588 (JP)**
• **KUNITAKE, Tomokatsu**
  **Kitakyushu-shi, Fukuoka, 807-8588 (JP)**

(74) Representative: **Stöckeler, Ferdinand**
**Schoppe, Zimmermann, Stöckeler**
**Zinkler, Schenk & Partner mbB**
**Patentanwälte**
**Radlkoferstrasse 2**
**81373 München (DE)**

(54) **METAL COMPONENT**

(57)     Provided is a metal component used for manufacturing a semiconductor device, the metal component including: a substrate having a conductivity; a nickel layer formed on a portion of a surface of the substrate and containing nickel as a main component; and a noble metal layer formed on a surface of the nickel layer.

FIG. 1B

## Description

BACKGROUND

1. Technical Field

A disclosed embodiment relates to a metal component.

2. Related Art

Conventionally, there has been known a technique for forming a nickel plating layer on a surface of a metal substrate of a metal component such as a lead frame used for manufacturing a semiconductor device. Further, as an example thereof, a technique called preplated lead frame (Pd-PPF) is known (see JP-A-04-115558). In this technique, the nickel plating layer, a palladium plating layer, and a gold plating layer are formed in this order on the surface of the metal substrate of the lead frame.

However, nickel constituting the nickel plating layer is a magnetic material. Therefore, when the semiconductor device is operated at a high frequency, conductor loss of the semiconductor device increases in the nickel plating layer.

One aspect of the embodiment has been made in view of the above. An object of the one aspect of the embodiment is to provide a metal component used for manufacturing a semiconductor device that can be operated efficiently at a high frequency.

SUMMARY

A metal component used for manufacturing a semiconductor device includes: a substrate having a conductivity; a nickel layer formed on a portion of a surface of the substrate and containing nickel as a main component; and a noble metal layer formed on a surface of the nickel layer.

BRIEF DESCRIPTION OF DRAWINGS

Fig. 1A is a schematic diagram of a lead frame according to an embodiment;
Fig. 1B is a cross-sectional view illustrating a semiconductor device according to the embodiment;
Fig. 2A is an enlarged cross-sectional view of the lead frame according to the embodiment; and
Fig. 2B is an enlarged cross-sectional view of the lead frame according to a modification of the embodiment.

DETAILED DESCRIPTION

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

A metal component used for manufacturing a semiconductor device, according to one aspect of an embodiment, includes a substrate, a nickel layer, and a noble metal layer. The substrate has a conductivity. The nickel layer is formed on a portion of a surface of the substrate and contains nickel as a main component. The noble metal layer is formed on a surface of the nickel layer.

According to the one aspect of the embodiment, the semiconductor device can be operated efficiently at a high frequency.

A lead frame will be described below as an example of the metal component used for manufacturing the semiconductor device, disclosed in the present application with reference to the accompanying drawings. Note that embodiments described below do not limit a technique of the present disclosure.

Further, the drawings are schematic. It should be noted that dimensional relationships between elements, ratios of the elements, and the like described in the drawings may differ from reality. Furthermore, also between the drawings, the dimensional relationships between the elements and the ratios of the elements illustrated in the drawings may differ from one drawing to another.

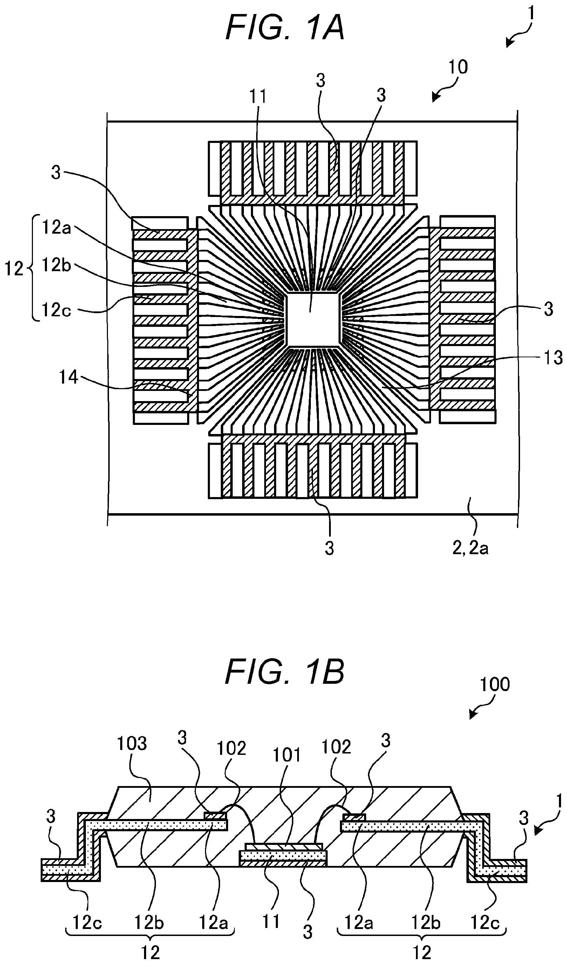

Fig. 1A is a schematic diagram of a lead frame 1 according to an embodiment. Fig. 1B is a cross-sectional view illustrating a semiconductor device 100 according to the embodiment.

The lead frame 1 illustrated in Fig. 1A is a lead frame used for manufacturing a quad flat package (QFP) type semiconductor device 100. Note that the technique of the present disclosure may be applied to a lead frame used for manufacturing other types of semiconductor devices such as small outline package (SOP), or quad flat non-lead package (QFN) having a lead exposed on a back surface of the semiconductor device.

The lead frame 1 according to the embodiment has, for example, a strip shape in plan view. For example, a plurality of unit lead frames 10 are formed side by side in a longitudinal direction of the lead frame 1. Such a unit lead frame 10 is a portion corresponding to each semiconductor device 100 manufactured using the lead frame 1. Note that the plurality of unit lead frames 10 may be formed side by side not only in the longitudinal direction but also in a width direction of the lead frame 1.

As illustrated in Fig. 1A, the unit lead frame 10 has a die pad 11, a plurality of leads 12, a die pad support portion 13, and a dam bar 14. Note that although not shown in Fig 1A, pilot holes may be provided side by side on a side surface on a long side of the lead frame 1.

The die pad 11 is provided, for example, in a central portion of the unit lead frame 10. A semiconductor element 101 can be mounted on a front surface side of the die pad 11 as illustrated in Fig. 1B.

The die pad 11 is connected to an outer edge portion of the unit lead frame 10 by the die pad support portion 13 and supported by the unit lead frame 10. Such a die pad support portion 13 is provided, for example, at each of four corners of the die pad 11.

The plurality of leads 12 are arranged side by side around the die pad 11. A tip portion 12a of each lead 12 extends from the outer edge portion of the unit lead frame 10 toward the die pad 11. As illustrated in Fig. 1B, such a lead 12 functions as a connection terminal of the semiconductor device 100.

The lead 12 has a tip portion 12a, an intermediate portion 12b, and a base end portion 12c. As illustrated in Fig. 1B, in the semiconductor device 100, a bonding wire 102 including Cu, a Cu alloy, Au, an Au alloy, or the like is connected to the tip portion 12a of the lead 12. Therefore, the lead frame 1 is required to have high bonding characteristics with the bonding wire 102. The dam bar 14 connects adjacent leads 12 to each other.

The semiconductor device 100 has a sealing resin 103 in addition to the lead frame 1, the semiconductor element 101, and the bonding wire 102. The sealing resin 103 is configured to contain, for example, an epoxy resin or the like. The sealing resin 103 is molded into a predetermined shape by a molding process or the like. The sealing resin 103 seals the semiconductor element 101, the bonding wire 102, the die pad 11, and the like.

Further, the base end portion 12c of the lead 12 functions as an external terminal (outer lead) of the semiconductor device 100 and is solder-bonded to a board. Further, in the semiconductor device 100 of the type having a back surface of the die pad 11 exposed from the sealing resin 103 and in the semiconductor device 100 of the type having the heat slug provided, the back surface of the semiconductor device 100 is solder-bonded to the board. Therefore, the lead frame 1 is required to have high wettability to solder.

Note that the dam bar 14 has a function as a dam for decreasing leakage of the resin used to the base end portion 12c (outer lead) side in the molding process of molding the sealing resin 103. The dam bar 14 is finally cut in a manufacturing process of the semiconductor device 100. The intermediate portion 12b of the lead 12 connects the tip portion 12a and the base end portion 12c.

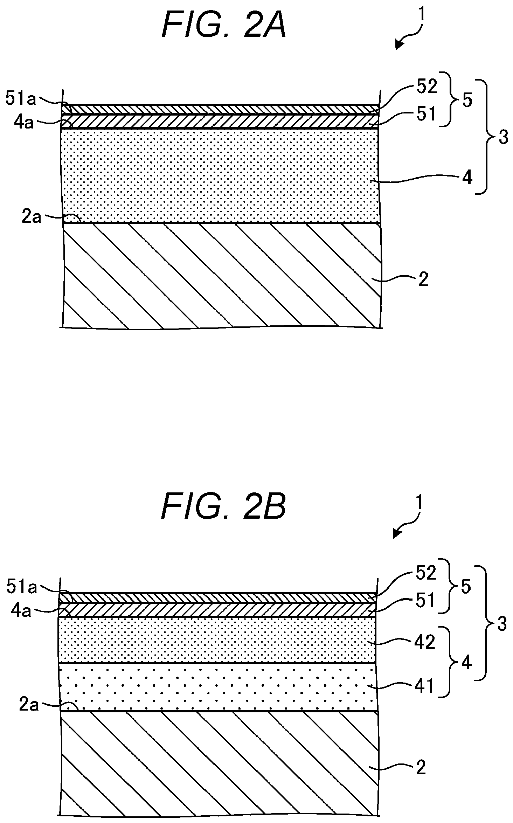

Fig. 2A is an enlarged cross-sectional view of the lead frame 1 according to the embodiment. As illustrated in Fig. 2A, the lead frame 1 according to the embodiment includes a conductive substrate 2 and a metal layer 3. The substrate 2 is configured to include a material (for example, a metal material such as copper or copper alloy) having a conductivity.

The metal layer 3 has a nickel layer 4 and a noble metal layer 5. The nickel layer 4 is formed on a portion of a surface 2a of the substrate 2. The nickel layer 4 contains nickel (Ni) as a main component. The nickel layer 4 can be formed, for example, by nickel plating.

The noble metal layer 5 is formed on a surface 4a of the nickel layer 4. The noble metal layer 5 contains at least one of palladium (Pd), platinum (Pt), gold (Au), and silver (Ag) as a main component. Note that the noble metal layer 5 may be a single layer, or may be a plurality of layers.

For example, in an example of Fig. 2A, noble metal layer 5 includes a palladium layer 51 and a gold layer 52. The palladium layer 51 is formed on the surface 4a of the nickel layer 4. The gold layer 52 is formed on a surface 51a of the palladium layer 51.

The palladium layer 51 contains palladium as a main component. The palladium layer 51 can be formed, for example, by palladium plating. The gold layer 52 contains gold as a main component. The gold layer 52 can be formed, for example, by gold plating.

The noble metal layer 5 is configured to contain a noble metal that is difficult to oxidize. Thus, in the lead frame 1 according to the embodiment, formation of oxide on a surface of the metal layer 3 can be restrained. Therefore, according to the embodiment, it is possible to form the lead frame 1 in which wettability of the solder and the bonding characteristics of the bonding wire 102 (see Fig. 1B) are compatible.

Note that the noble metal layer 5 according to the embodiment is not limited to being configured to include the palladium layer 51 and the gold layer 52, and may be configured to further include a silver layer containing silver as a main component. Further, the noble metal layer 5 according to the embodiment may be configured to have only the silver layer.

Here, in an embodiment, as illustrated in Figs. 1A and 1B, the metal layer 3 including the nickel layer 4 (see Fig. 2A) is formed on only a portion of a surface of the lead frame 1 rather than on the entire surface of the lead frame 1.

For example, as illustrated in Fig. 1B, in the lead frame 1, the metal layer 3 is formed on front and back surfaces of the substrate 2 (see Fig. 2A) at the base end portion 12c, the front surface of the substrate 2 at the tip portion 12a, and the back surface of the substrate 2 at the die pad 11.

Thus, a volume of the nickel layer 4 provided in the lead frame 1 is reduced compared to a case where the metal layer 3 is formed on the entire surface of the lead frame 1. That is, in the embodiment, a volume of nickel, which is a magnetic material, in the lead frame 1 can be reduced. Therefore, conductor loss of the semiconductor device 100 caused by such nickel is reduced.

Therefore, according to the embodiment, the semiconductor device 100 can operate efficiently at a high frequency.

Note that in the present disclosure, a location in which the metal layer 3 is disposed in the lead frame 1 is not limited to a location illustrated in Fig. 1B. For example, the metal layer 3 may also be disposed on the front surface of the substrate 2 in the die pad 11. Thus, the semiconductor element 101 can be solder-bonded to a front surface of the die pad 11.

Further, in the embodiment, the nickel layer 4 may contain phosphorus (P) in a predetermined ratio (for example, 0.01 wt% to 1 wt%). This makes it difficult for the copper contained in the substrate 2 to diffuse within the nickel layer 4. A reason for this is presumed to be that within the nickel layer 4, phosphorus concentrated at an interface between adjacent crystal grains inhibits diffusion of the copper.

Therefore, according to the embodiment, a thickness of the nickel layer 4 can be reduced. Thus, the volume of nickel, which is the magnetic material, can be further reduced. Therefore, according to the embodiment, the semiconductor device 100 can operate more efficiently at a high frequency.

Note that the present disclosure is not limited to a case where the nickel layer 4 contains phosphorus, and the nickel layer 4 may not contain phosphorus.

Fig. 2B is an enlarged cross-sectional view of the lead frame 1 according to a modification of the embodiment. As illustrated in Fig. 2B, the nickel layer 4 may have a two-layer structure. The nickel layer 4 according to this modification includes a first nickel layer 41 and a second nickel layer 42.

The first nickel layer 41 is a nickel layer containing no phosphorus. Note that in the present disclosure, "containing no phosphorus" includes a case where phosphorus, which is an unavoidable impurity, is contained. The second nickel layer 42 is a nickel layer containing phosphorus in the predetermined ratio (for example, 0.01 wt % to 1 wt %).

Even with such a configuration, the phosphorus contained in the second nickel layer 42 makes it difficult for the copper contained in the substrate 2 to diffuse within the nickel layer 4. Thus, the thickness of the nickel layer 4 as a whole can be reduced, so that the volume of nickel, which is the magnetic material, can be further reduced.

Therefore, according to the modification, the semiconductor device 100 can operate more efficiently at a high frequency.

In an example of Fig. 2B, the first nickel layer 41 containing no phosphorus is located on the substrate 2 side, and the second nickel layer 42 containing phosphorus is located on the noble metal layer 5 side. However, the present disclosure is not limited to such an example. For example, the second nickel layer 42 containing phosphorus may be located on the substrate 2 side, and the first nickel layer 41 containing no phosphorus may be located on the noble metal layer 5 side.

Further, in the embodiment, the conductor loss $\alpha c$ (dB) of the nickel layer 4 in the semiconductor device 100 may satisfy the following formula (1).

$$\alpha c \leq (6.0 \cdot 10^{-12} \cdot K_3 \cdot f^{1/2})/W \text{ --- } (1)$$

Here, $K_3$ is a constant determined by a shape of the nickel layer 4, and when expressed using a characteristic impedance $Z_0$, $K_3 = \pi^{1/2}/2Z_0$. Further, f is an operating frequency (Hz) of the semiconductor device 100. W is a width (m) of the nickel layer 4.

Thus, by setting the conductor loss of the nickel layer 4 in the semiconductor device 100 to be equal to or less than a value defined by the formula (1), the semiconductor device 100 can operate efficiently at a high frequency f.

Further, in the embodiment, the conductor loss $\alpha c$ (dB) of the nickel layer 4 in the semiconductor device 100 may satisfy the following formula (2).

$$\alpha c \leq (3.7 \cdot 10^{-12} \cdot K_3 \cdot f^{1/2})/W \text{ --- } (2)$$

Thus, by setting the conductor loss of the nickel layer 4 in the semiconductor device 100 to be equal to or less than a value defined by the formula (2), the semiconductor device 100 can operate efficiently at the high frequency f.

Further, in the embodiment, the conductor loss $\alpha c$ (dB) of the nickel layer 4 in the semiconductor device 100 may satisfy the following formula (3).

$$\alpha c \leq (1.5 \cdot 10^{-12} \cdot K_3 \cdot f^{1/2})/W \text{ --- } (3)$$

Thus, by setting the conductor loss of the nickel layer 4 in the semiconductor device 100 to be equal to or less than a value defined by the formula (3), the semiconductor device 100 can operate efficiently at the high frequency f.

Further, in the embodiment, the conductor loss $\alpha c$ (dB) of the nickel layer 4 in the semiconductor device 100 may satisfy the following formula (4).

$$\alpha c \geq (3.8 \cdot 10^{-13} \cdot K_3 \cdot f^{1/2})/W \text{ --- } (4)$$

Thus, by setting the conductor loss of the nickel layer 4 in the semiconductor device 100 to be equal to or greater than a value defined by the formula (4), it is possible to restrain the nickel layer 4 from becoming too thin. This makes it difficult for the copper contained in the substrate 2 to diffuse within the nickel layer 4.

Therefore, according to the embodiment, reliability of the semiconductor device 100 is improved.

Further, in the embodiment, the conductor loss $\alpha c$ (dB) of the nickel layer 4 in the semiconductor device 100 may satisfy the following formula (5).

$$\alpha c \geq (7.6 \cdot 10^{-13} \cdot K_3 \cdot f^{1/2})/W \text{ --- } (5)$$

Thus, by setting the conductor loss of the nickel layer 4 in the semiconductor device 100 to be equal to or greater than a value defined by the formula (5), it is possible to restrain the nickel layer 4 from becoming too thin. This makes it difficult for the copper contained in the substrate 2 to diffuse within the nickel layer 4.

Therefore, according to the embodiment, the reliability of the semiconductor device 100 is improved.

Further, in the embodiment, the surface 2a of the substrate 2 on which the nickel layer 4 is not formed may be a rough surface among surfaces 2a of the substrate 2. Such a rough surface is provided, for example, by oxidizing the surface 2a of the substrate 2 containing copper to form acicular oxide.

This can improve adhesion between the lead frame 1 and the sealing resin 103 (see Fig. 1B), thereby improving the reliability of the semiconductor device 100.

Note that in the present disclosure, the rough surface of the base material 2 is not limited to a case of including acicular oxide. The rough surface of the substrate 2 may be a rough surface formed by other methods. Further, in the present disclosure, the surface 2a of the substrate 2 on which the nickel layer 4 is not formed need not be a rough surface.

The embodiments of the present disclosure have been described above. However, the technique of the present disclosure is not limited to the above-described embodiments. Various modifications can be made without departing from the gist of the present disclosure. For example, another metal layer may be provided between the substrate of the lead frame and the nickel layer.

Further advantageous effects and modifications can be easily derived by those skilled in the art. Therefore, the broader aspects of the technique of the present disclosure are not limited to the specific details and representative embodiments presented and described above. Accordingly, various changes can be made without departing from the spirit or scope of the general technical concept defined by the appended claims and equivalents thereof.

The present technique can employ the following configurations:

[1] A metal component used for manufacturing a semiconductor device, the metal component including: a substrate having a conductivity; a nickel layer formed on a portion of a surface of the substrate and containing nickel as a main component; and a noble metal layer formed on a surface of the nickel layer.

[2] The metal component according to [1], in which conductor loss $\alpha c$ (dB) of the nickel layer in the semiconductor device satisfies following formula (1):

$$\alpha c \leq (6.0 \cdot 10^{-12} \cdot K_3 \cdot f^{1/2})/W \text{ --- (1)}$$

where;

$K_3$: constant determined by a shape of the nickel layer;
f: operating frequency of the semiconductor device (Hz); and
W: width of the nickel layer (m).

[3] The metal component according to [1], in which conductor loss $\alpha c$ (dB) of the nickel layer in the semiconductor device satisfies following formula (2):

$$\alpha c \leq (3.7 \cdot 10^{-12} \cdot K_3 \cdot f^{1/2})/W \text{ --- (2)}$$

where;

$K_3$: constant determined by a shape of the nickel layer;
f: operating frequency of the semiconductor device (Hz); and
W: width of the nickel layer (m).

[4] The metal component according to [1], in which conductor loss $\alpha c$ (dB) of the nickel layer in the semiconductor device satisfies following formula (3):

$$\alpha c \leq (1.5 \cdot 10^{-12} \cdot K_3 \cdot f^{1/2})/W \text{ --- (3)}$$

where;

$K_3$: constant determined by a shape of the nickel layer;
f: operating frequency of the semiconductor device (Hz); and
W: width of the nickel layer (m).

[5] The metal component according to any one of [1] to [4], in which the nickel layer contains phosphorus.
[6] The metal component according to any one of [1] to [4], in which the nickel layer includes a first nickel layer containing no phosphorus and a second nickel layer containing phosphorus.
[7] The metal component according to any one of [1] to [4], in which the noble metal layer contains at least one of palladium, platinum, gold, and silver as a main component.
[8] The metal component according to any one of [1] to [4], in which a surface of the substrate on which the nickel layer is not formed is a rough surface among surfaces of the substrate.

**Claims**

1. A metal component used for manufacturing a semiconductor device, the metal component comprising:

   a substrate having a conductivity;

a nickel layer formed on a portion of a surface of the substrate and containing nickel as a main component; and
a noble metal layer formed on a surface of the nickel layer.

**2.** The metal component according to claim 1, wherein conductor loss $\alpha c$ (dB) of the nickel layer in the semiconductor device satisfies following formula (1):

$$\alpha c \leq (6.0 \cdot 10^{-12} \cdot K_3 \cdot f^{1/2})/W \text{ --- } (1)$$

where;

$K_3$: constant determined by a shape of the nickel layer;
f: operating frequency of the semiconductor device (Hz); and
W: width of the nickel layer (m).

**3.** The metal component according to claim 1, wherein conductor loss $\alpha c$ (dB) of the nickel layer in the semiconductor device satisfies following formula (2):

$$\alpha c \leq (3.7 \cdot 10^{-12} \cdot K_3 \cdot f^{1/2})/W \text{ --- } (2)$$

where;

$K_3$: constant determined by a shape of the nickel layer;
f: operating frequency of the semiconductor device (Hz); and
W: width of the nickel layer (m).

**4.** The metal component according to claim 1, wherein conductor loss $\alpha c$ (dB) of the nickel layer in the semiconductor device satisfies following formula (3):

$$\alpha c \leq (1.5 \cdot 10^{-12} \cdot K_3 \cdot f^{1/2})/W \text{ --- } (3)$$

where;

$K_3$: constant determined by a shape of the nickel layer;
f: operating frequency of the semiconductor device (Hz); and
W: width of the nickel layer (m).

**5.** The metal component according to any one of claims 1 to 4, wherein the nickel layer contains phosphorus.

**6.** The metal component according to any one of claims 1 to 4, wherein the nickel layer includes a first nickel layer containing no phosphorus and a second nickel layer containing phosphorus.

**7.** The metal component according to any one of claims 1 to 4, wherein the noble metal layer contains at least one of palladium, platinum, gold, and silver as a main component.

**8.** The metal component according to any one of claims 1 to 4, wherein a surface of the substrate on which the nickel layer is not formed is a rough surface among surfaces of the substrate.

## FIG. 1A

## FIG. 1B

## FIG. 2A

## FIG. 2B

Europäisches
Patentamt

European
Patent Office

Office européen
des brevets

## EUROPEAN SEARCH REPORT

Application Number

EP 23 19 3937

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/131218 A1 (LI WU HU [SG] ET AL) 2 May 2019 (2019-05-02) * paragraph [0004] – paragraph [0005]; claims 1, 4, 10, 11 * * paragraph [0030] – paragraph [0032] * * paragraph [0035] * * paragraph [0061] – paragraph [0063] * * paragraph [0066] – paragraph [0067] * ----- | 1-8 | INV. H01L23/495 ADD. C25D5/12 C25D5/14 C23C18/16 |
| X | JP S59 36954 A (HITACHI CABLE) 29 February 1984 (1984-02-29) * the whole document * ----- | 1-4,7,8 | |

TECHNICAL FIELDS
SEARCHED (IPC)

H01L

The present search report has been drawn up for all claims

| Place of search | Date of completion of the search | Examiner |
|---|---|---|
| The Hague | 15 December 2023 | Telias, Gabriela |

EPO FORM 1503 03.82 (P04C01)

**EP 4 333 052 A1**

## ANNEX TO THE EUROPEAN SEARCH REPORT
## ON EUROPEAN PATENT APPLICATION NO.

EP 23 19 3937

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2023

| Patent document cited in search report | Publication date | Patent family member(s) | Publication date |
|---|---|---|---|
| US 2019131218 A1 | 02-05-2019 | NONE | |
| JP S5936954 A | 29-02-1984 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4115558 A